**Europäisches Patentamt**

**European Patent Office**

**Office européen des brevets**

(19)

(11) Numéro de publication: **0 124 428**
**B1**

(12) # FASCICULE DE BREVET EUROPEEN

(45) Date de publication du fascicule du brevet:
14.09.88

(21) Numéro de dépôt: **84400811.0**

(22) Date de dépôt: **20.04.84**

(51) Int. Cl.⁴: **H 01 L 23/46,** H 01 L 23/36

(54) Support allégé pour composants électroniques.

(30) Priorité: **21.04.83 FR 8306544**

(43) Date de publication de la demande:
**07.11.84 Bulletin 84/45**

(45) Mention de la délivrance du brevet:
**14.09.88 Bulletin 88/37**

(84) Etats contractants désignés:
**BE CH DE GB IT LI NL SE**

(56) Documents cités:
**FR - A - 1 481 645**
**FR - A - 2 511 193**

**ELECTRONICS INTERNATIONAL, vol. 54, no. 12, juin 1981, page 46; New York, US; J. LYMAN: "Copper plus invar suits chip-carriers"**

(73) Titulaire: **IMPHY S.A., Immeuble Elysées La Défense 19 Le Parvis, F-92072 ParisLa Défense (FR)**

(72) Inventeur: **Lestang, Michel, 3 Place Exelmans, F-78150 le Chesnay (FR)**
Inventeur: **Lagarde, Pierre, 18 rue de l'Orangerie, F-78000 Versailles (FR)**

(74) Mandataire: **Phélip, Bruno et al, c/o Cabinet Harlé & Phélip 21, rue de La Rochefoucauld, F-75009 Paris (FR)**

## Description

L'invention se rapporte à un support allégé pour composants électroniques et plus particulièrement pour composants électroniques en boîtier d'alumine sans fils de connexion.

La croissance en nombre et en complexité des fonctions demandées à l'électronique embarquée conduit à grouper un nombre toujours plus élevé de composants électroniques sur un même support. Mais cette tendance aggrave les problèmes d'encombrement, de fiabilité, de dissipation thermique et de poids.

Si la généralisation des boîtiers sans connexions a contribué à la réduction des encombrements, elle a fait apparaître des problèmes au niveau du support. En effet, ce support doit avoir un coefficient de dilatation adapté à celui des boîtiers puisqu'il n'est plus possible de compter sur la souplesse des fils de connexion pour rattraper les différences de dilatation. Par ailleurs, la tendance à augmenter le nombre des boîtiers impose au support des conditions de dimension et d'évacuation thermique toujours plus élevées.

Pour permettre l'évacuation de la chaleur, il a été proposé, par exemple, dans le document FR-A-1.481.645, de réaliser le support des composants sous forme d'une plaque creuse munie, à l'intérieur, d'une garniture à ailettes et dans laquelle circule un fluide de refroidissement.

Les supports en alumine constituent un excellent choix pour l'adaptation du coefficient de dilatation à celui du boîtier, mais dès que le nombre des composants rapportés devient trop important, on aboutit rapidement à des limites de prix et de dimensions liées notamment à leur fragilité.

On connaît également des supports formés par une plaque de matériaux métalliques colaminés, (comme le décrit, par exemple, le document «Electronics International» vol. 54, n° 12, Juin 1981, page 46). Ces plaques sont constituées, par exemple, d'une couche d'un métal peu dilatable, du type vendu sous la marque «Invar», entourée de deux couches de cuivre. Sur l'une de ces couches de cuivre, il peut être rapporté, si nécessaire, des radiateurs à ailettes de dissipation thermique. Cette solution élimine les problèmes de dimensions tout en permettant une adaptation précise du coefficient de dilatation et une bonne conductibilité thermique, mais elle présente cependant pour les matériels embarqués, un inconvénient. En effet, l'épaisseur du support nécessaire pour obtenir la rigidité cherchée entraîne un poids assez élevé par unité de surface, ce poids est encore augmenté lorsque l'on doit rapporter un radiateur de refroidissement, comme prévu dans le document FR-A-2.511.193.

D'autre part, la densification des matériels embarqués conduit à réduire au maximum la dimension des radiateurs avec souvent pour conséquence l'adaptation d'un refroidissement par convection forcée qui entraîne le montage de dispositifs d'échangeur complexes.

La présente invention propose, pour répondre à ces problèmes, une structure de support qui convient parfaitement au refroidissement par convection forcée, tout en réunissant les conditions recherchées de dilatabilité, de rigidité, de légèreté et de simplicité.

Suivant l'invention le support est constitué d'une feuille métallique ondulée placée entre deux feuilles métalliques lisses en matériaus co. laminés dont l'une au moins reçoit les composants électroniques.

Selon une autre caractéristique de l'invention, la feuille ondulée est également en matériaux métalliques colaminés.

L'invention sera mieux comprise à l'aide de la description suivante se rapportant à un mode de réalisation donné à titre d'exemple et en se référant aux dessins annexés qui représentent:

– Figure 1 une vue schématique en perspective d'une carte électronique comportant un support conforme à l'invention;

– Figure 2 une vue en coupe transversale à plus grande échelle du support de la carte électronique.

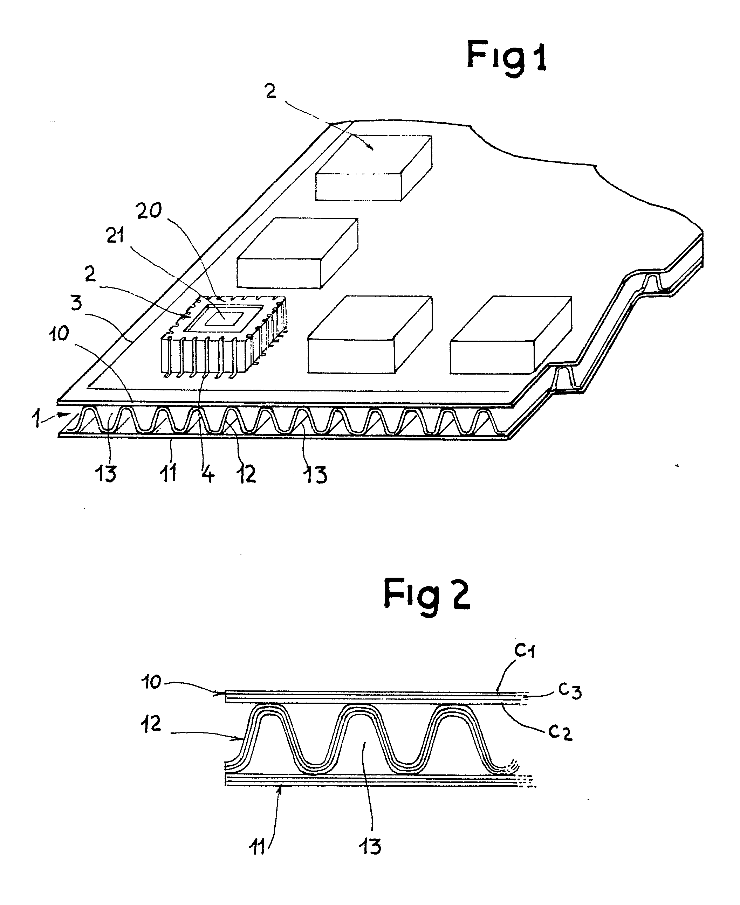

En se reportant tout d'abord à la figure 1, la carte électronique se compose d'un support désigné dans son ensemble par la référence 1 et de composants électroniques 2.

Le support 1 est formé par deux feuilles métalliques lisses 10 et 11 qui encadrent une feuille métallique ondulée 12 formant le noyau du support 1. Ces trois feuilles (10–11–12) sont assemblées entre elles par brasage ou soudage.

La feuille ondulée 12 forme donc entre les deux feuilles lisses des canaux 13 pour la circulation d'un fluide de refroidissement dans l'ensemble de la carte électronique.

Les composants électroniques 2 sont formés par des petits boîtiers d'alumine 20 renfermant chacun une pastille ou puce 21, ces boîtiers étant directement rapportés sur l'une ou sur les deux faces (10–11) par l'intermédiaire des points de connexion 4 d'une très mince pellicule multicouche isolante 3.

Les deux feuilles lisses (10–11) et la feuille ondulée 12 sont chacune en matériaux métalliques colaminés par exemple deux couches de cuivre $C_1$–$C_2$ entourant une couche «d'Invar» $C_3$. Les rapports d'épaisseur de cet ensemble colaminé sont choisis pour que le coefficient de dilatation résultant soit voisin de celui des boîtiers d'alumine 20 des composants électroniques 2. L'épaisseur des feuilles (10–11–12) du support 1 est généralement choisie entre 100 et 300 microns et n'est pas obligatoirement la même pour les trois feuilles. L'intervalle entre les deux feuilles (10–11) du support 1 peut être choisi autour de 2 millimètres.

Cette structure du support d'une grande simplicité de réalisation, assure une très bonne évacuation thermique grâce à la bonne conductibilité des couches de cuivre et la possibilité d'un refroidissement par circulation de fluide dans les ondulations. De plus elle permet d'obtenir, avec un faible poids, une bonne rigidité même pour des grandes dimensions et également de rapporter les composants sur les deux faces du support.

## Revendications

1. Support allégé destiné à recevoir des composants électroniques en boîtier sans fils de connexion et formé par des matériaux métalliques colaminés pour adapter le coefficient de dilatation thermique du support à celui des boîtiers, caractérisé en ce que le support est constitué d'une feuille (12) métallique ondulée fixée entre deux feuilles lisses (10, 11) dont l'une au moins reçoit les composants électroniques et en ce que les deux feuilles lisses et la feuille ondulée sont en des matériaux métalliques colaminés.

2. Support allégé selon la revendication 1, caractérisé par le fait que les rapport d'épaisseur des matériaux métalliques colaminés des feuilles (10–11–12) sont déterminés pour obtenir un coefficient de dilatation résultant adapté à celui des boîtiers (20) des composants (2).

3. Support allégé selon les revendications 1 et 2, caractérisé par le fait que les matériaux métalliques colaminés des feuilles (10–11–12) sont formés par une couche «d'Invar» ($C_3$) entourée de deux couches de cuivres ($C_1$–$C_2$).

## Claims

1. Light-weight support intended to receive electronic components in leadless chipcarrier and formed from pack-rolled metal materials to adjust the coefficient of thermal expansion of the support to that of the housings, characterized in that the support is composed of a corrugated metal sheet (12) fixed between two smooth sheets (10, 11), of which at least one receives the electronic components, and in that the two smooth sheets and the corrugated sheet are of pack-rolled metal materials.

2. Light-weight support according to Claim 1, characterized in that the ratios between the thicknesses of the pack-rolled metal materials of the sheets (10, 11, 12) are set to obtain a resulting coefficient of expansion adjusted to that of the housings (20) of the components (2).

3. Light-weight support according to Claims 1 and 2, characterized in that the pack-rolled metal materials of the sheets (10, 11, 12) are formed from a layer of «Invar» ($C_3$) surrounded by two layers of copper ($C_1$, $C_2$).

## Patentansprüche

1. Erleichterter Träger zur Aufnahme von elektronischen Bauteilen in Gehäuse ohne Verbindungsleiter, bestehend aus zusammengewalzten metallischen Werkstoffen zum Anpassen des Wärmedehnungskoeffizienten des Trägers an denjenigen der Gehäuse, dadurch gekennzeichnet, dass der Träger aus einer gewellten Metallfolie (12) besteht, die zwischen zwei glatten Folien (10, 11) befestigt ist, von denen mindestens die eine die elektronischen Bauteile aufnimmt, wobei die beiden glatten Folien (10, 11) und die gewellte Folie (12) aus zusammengewalzten Metallwerkstoff bestehen.

2. Erleichterter Träger nach Anspruch 1, dadurch gekennzeichnet, dass die Dickenverhältnisse der zusammengewalzten Metallwerkstoffe (10, 11, 12) so gewählt sind, dass der resultierende Ausdehnungskoeffizient an denjenigen der Gehäuse (20) der Bauteile (2) angepasst ist.

3. Erleichterter Träger nach Anspruch 1 und 2, dadurch gekennzeichnet, dass die zusammengewalzten Metallwerkstoffe der Folien (10, 11, 12) aus einer von zwei Schichten Kupfer ($C_1$) ($C_2$) eingefassten Schicht aus «Invar» ($C_3$) bestehen.

# Fig 1

# Fig 2